# EUROPÄISCHE PATENTSCHRIFT

(11) **EP 1 617 487 B1**
(45) Veröffentlichungstag und Bekanntmachung des Hinweises auf die Patenterteilung: **04.06.2008**
(21) Anmeldenummer: 05105204.1
(22) Anmeldetag: 14.06.2005
(51) Int. Cl.: H01L 31/048

(54) **Solarmodul als Verbundsicherheitsglas**
Solar module as a safety glass
Module de cellules solaires composé comme un verre de sécurité

(30) Priorität: 23.06.2004 DE 102004030411
(43) Veröffentlichungstag der Anmeldung: 18.01.2006
(73) Patentinhaber: Kuraray Europe GmbH, 65926 Frankfurt am Main (DE)
(72) Erfinder: Koll, Bernhard, 53757, St. Augustin (DE)
(74) Vertreter: Kisters, Michael Marcus

(56) Entgegenhaltungen:
- DE-U1- 20 302 045

## Beschreibung

### Technisches Gebiet

Die Erfindung betrifft als Verbundsicherheitsglas ausgeführte Solarmodule unter Verwendung einer auf Polyvinylbutyral (PVB) basierenden Folie, ein Verfahren zur Herstellung der Solarmodule und deren Verwendung.

### Stand der Technik

Solarmodule bestehen in der Regel aus einer photosensitiven Halbleiterschicht (im folgenden als Solarzelleneinheit bezeichnet), die zum Schutz gegen äußere Einflüsse mit einer transparenten Abdeckung versehen werden. Die Solarzelleneinheiten werden häufig zwischen eine Glasscheibe und eine rigide, hinteren Abdeckplatte z.B. aus Glas mit Hilfe eines transparenten Klebers laminiert. Der transparente Kleber muss die Solarzelleneinheiten vollständig umschließen, UV-stabil sein und nach dem Laminierprozess vollständig blasenfrei sein.

Da die Solarzelleneinheiten äußerst bruchempfindlich sind, werden als transparente Kleber häufig aushärtende Gießharze oder vernetzbare, auf Ethylenvinylacetat (EVA) basierende Systeme eingesetzt, so wie beispielsweise in DE 41 22 721 C1 oder DE 41 28 766 A1 offenbart. Diese Klebesysteme können im ungehärteten Zustand so niedrigviskos eingestellt werden, dass sie die Solarzelleneinheiten blasenfrei umschließen. Nach Zugabe eines Härters oder Vernetzungsmittels wird eine mechanisch widerstandfähige Klebeschicht erhalten. Nachteilig an solchen Solarmodulen ist deren aufwändige Herstellung; insbesondere bei großflächigen Fassadenelementen ist die Einbettung der Solarzelleneinheiten in das flüssige Gießharz und dessen kontrollierte Aushärtung ein schwierig zu kontrollierender Prozess. Zudem neigen einige Gießharze nach einigen Jahren zur Blasenbildung bzw. Delamination.

Eine Alternative zu aushärtenden Klebesystemen ist der Einsatz von auf Polyvinylbutyral (PVB) basierenden Folien. Hier werden die Solarzelleneinheiten zwischen PVB-Folien eingebettet und diese unter erhöhtem Druck und erhöhter Temperatur mit den gewünschten Abdeckmaterialien zu einem Laminat verbunden. Verfahren zur Herstellung von Solarmodulen mit Hilfe von PVB-Folien sind z. B. durch DE 40 26 165 C2, DE 42 278 60 A1, DE 29 237 70 C2, DE 35 38 986 C2 oder US 4,321,418 bekannt. In diesen Publikationen dient die PVB-Folie lediglich zur Einbettung der Solarzelleneinheiten; Sicherheitsaspekte bzw. die hierfür erforderlichen Eigenschaften der PVB-Folie sind nicht beschrieben.

Die Verwendung von PVB-Folien in Solarmodulen als Verbundsicherheitsverglasungen ist in DE 20 302 045 U1 und DE 35 389 86 C2 offenbart. Diesen Schriften sind allerdings keine Angaben über die Sicherheitseigenschaften der Verbundgläser oder die Eigenschaften der verwendeten PVB-Folie zu entnehmen.

Die Sicherheitseigenschaften eines Verbunds aus Glas und PVB-Folie hängen bekanntermaßen von der Haftkraft zwischen Folie und Glas ab. Die Haftkraft sollte so hoch sein, dass bei der mechanischen Zerstörung des Glases ein Klebenbleiben der Glasbruchstücke an der Folie gewährleistet ist und scharfkantige Glassplitter sich nicht ablösen können. Bei hoher Haftkraft der Folie kann ein aufprallendes Objekt jedoch das Verbundglas durchdringen, da sich die PVB-Folie an der Auftreffstelle kaum elastisch verformt und nur wenig zum Abbremsen des Objektes beiträgt. Liegt die Haftung zum Glas auf einem niedrigeren Niveau, kann sich die PVB-Folie an der Auftreffstelle unter Dehnung vom Glas ablösen und verformen, wodurch das auftreffende Objekt abgebremst wird.

Da eine zu geringe Haftung der PVB-Folie am Glas das Ablösen von Glasbruchstücken von der Folie erleichtert und somit das Splitterrisiko erhöht, strebt man in der Praxis einen Kompromiss zwischen hoher und niedriger Haftkraft, also ein mittleres Haftungsniveau an. Dieses ist insbesondere bei Verbundsicherheitsscheiben für Kraftfahrzeuge der Fall, wo eine hohe Penetrationshemmung wichtig ist. Verbundsicherheitsscheiben für den Baubereich, insbesondere bei Überdachungen, benötigen eine gute Splitterbindung, sodass die PVB-Folie eine relativ hohe Haftung zwischen Glas und Klebefolie aufweisen sollte.

Solarmodule werden in zunehmenden Maße in Gebäuden als Fassadenelemente oder Dachflächen eingesetzt. Diese Module müssen neben einer guten photovoltaischen Lichtausbeute auch mit Verbundsicherheitsverglasungen vergleichbare Eigenschaften aufweisen. Die beschriebenen Solarmodule weisen in PVB-Folie eingebettete Solarzellen auf, die jedoch die Sicherheitseigenschaften von Verbundsicherheitsglas nicht besitzen.

### Aufgabe

Aufgabe der vorliegenden Erfindung ist es daher, Solarmodule mit den Eigenschaften von Verbundsicherheitsverglasungen unter Verwendung von Folien auf Basis von PVB bereit zu stellen.

### Darstellung der Erfindung

Die Sicherheitseigenschaften von Verbundverglasungen werden insbesondere durch die verwendete Zwischenschichtfolie, hier PVB-Folie, bestimmt. Insbesondere die Penetration der Verglasung ist zu vermeiden, sodass die PVB-Folie eine ausreichende Reissfestigkeit aufweisen muss.

Gegenstand der vorliegenden Erfindung sind daher Solarmodule als Verbundsicherheitsgläser, umfassend ein Laminat aus
a) einer Glasscheibe
b) mindestens einer Solarzelleneinheit, die zwischen zwei auf PVB basierenden Folien angeordnet ist und
c) einer rückwärtigen Abdeckung,
   wobei mindestens eine der auf PVB basierenden Folien eine Reissfestigkeit gemäß EN ISO 527/3 von mindestens 16 N/mm² aufweist.

Weiterhin ist Gegenstand der Erfindung ein Verfahren zur Herstellung eines Solarmoduls als Verbundsicherheitsglas, durch Bereitstellen eines Körpers aus
a) einer Glasscheibe,
b) mindestens einer Solarzelleneinheit, die zwischen zwei auf PVB basierenden Folien angeordnet ist, wobei mindestens eine Folie eine Reissfestigkeit gemäß EN ISO 527/3 von mindestens 16 N/mm² aufweist und
c) einer rückwärtigen Abdeckung
   durch Laminieren des Körpers unter erhöhtem oder verringertem Druck und erhöhter Temperatur.

Die Laminierung erfolgt unter einer Verschmelzung der Folien, so dass eine blasen- und schlierenfreie Verbindung der auf PVB basierenden Folien miteinander erhalten wird.

Geeignete Folien auf Basis von PVB enthalten neben 50-80 Gew.% PVB 50-20 Gew.% Weichmacher und geringe Mengen an Haftungsregulatoren, Antiblockingmitteln und UV-Stabilisatoren. Folien dieser Art werden im folgenden kurz als PVB-Folien bezeichnet. Die prinzipielle Herstellung und Zusammensetzung von PVB-Folien für Verbundsicherheitsverglasungen ist z. B. in EP 185 863 B1, EP 1 118 258 B1 oder WO 02/102591 A1 beschrieben. Die hier offenbarten PVB-Folien können durch Art und/oder Menge des Weichmachers oder Art und Molekulargewicht des PVB-Harzes bzw. dessen Vernetzung an die geforderte Reissfestigkeit angepasst werden.

Zur Herstellung der erfindungsgemäßen Solarmodule mit Verbundsicherheitseigenschaften ist es erforderlich, das zumindest eine der PVB-Folien des Moduls die genannte Reissfestigkeit aufweist. Die andere Folie, bevorzugt die an die rückwärtige Abdeckung angrenzende Folie, kann eine geringere Festigkeit aufweisen. Bevorzugt besitzen beide PVB-Folien die gleiche Reissfestigkeit, besonders bevorzugt ist die Zusammensetzung beider Folien identisch.

In einer besonderen Ausführungsform der vorliegenden Erfindung besitzt das Solarmodul schalldämmende Eigenschaften, indem mindestens eine, bevorzugt beide der Folien Schallschutzeigenschaften aufweist. Schallschutzfolien auf Basis von PVB sind z. B. in EP 1 118 258 B1 oder EP 387 148 B1 beschrieben. Schallschutzfolien gemäß EP 1 118 258 B1 erhöhen die Schalldämmung eines Verbundsicherheitsglases bei dessen Koinzidenzfrequenz im Bereich von 1.000 bis 3.500 Hz um mindestens 2 dB, gemessen nach DIN EN ISO 717.

Geeignete schalldämmende Folien enthalten gemäß EP 1118258 B1:
- 50 bis 80 Gew.-% PVB (teilacetalisierter Polyvinylalkohol)
- 20 bis 50 Gew.-% einer Weichmachermischung, enthaltend
   - 30 bis 70 Gew.-% - gerechnet als Anteil an der Weichmachermischung - eines oder mehrerer Polyalkylenglykole der Gruppe bestehend aus
      - Polyalkylenglykolen der allgemeinen Formel
         HO-(R-O)ₙ-H mit R = Alkylen und n > 5
      - Derivate von Polyalkylenglykolen der allgemeinen Formel R₁-O-(R₂-O)ₙ-H mit R₂ = Alkylen und n ≥ 2, bei denen der Wasserstoff von einer der beiden terminalen Hydroxygruppen des Polyalkylenglykols mit einem organischen Rest R₁ verknüpft ist
      - Derivate von Polyalkylenglykolen der allgemeinen Formel R₁-O-(R₂-O)ₙ-R₃ mit R₂ = Alkylen und n > 5, bei denen der Wasserstoff von beiden terminalen Hydroxygruppen des Polyalkylenglykols mit einem organischen Rest R₁ bzw. R₃ verknüpft ist.
   - 70 bis 30 Gew.-% - gerechnet als Anteil an der Weichmachermischung - eines oder mehrerer Standardweichmacher wie Di-n-hexyladipat (DHA) und Triethylenglycol-bis-n-heptanoat (3G7).

Erfindungsgemäß einsetzbare PVB-Folien weisen vorzugsweise eine Reissfestigkeit nach EN ISO 527/3 von 16 bis 30 N/mm², insbesondere 16 bis 25 N/mm² und bevorzugt von 18 bis 23 N/mm² auf.

Die erfindungsgemäß einsetzbaren PVB-Folien müssen die Solarzelleneinheiten und deren elektrischen Anschlüsse blasenfrei und kraftschlüssig umschließen; gleichzeitig ist eine möglichst geringe Gesamtdicke der Solarmodule gefordert. Hierzu ist es zweckmäßig, dass unter den Herstellungsbedingungen zumindest eine PVB-Folie den eingelegten Solarzelleneinheiten "ausweicht", d. h. unter den Laminierbedingungen eine gewisse Fließfähigkeit aufweist.

Weichere, d.h. fließfähige Folien besitzen naturgemäß eine geringere Reißfestigkeit, sind aber einfacher zu verarbeiten. Zum Erhalt der gewünschten Sicherheitseigenschaften ist auf eine ausreichende Reißfestigkeit zu achten.

Geeignete PVB-Folien weisen daher bevorzugt eine der folgenden Schmelzflussindizes nach DIN 53735 (mit 2mm Düse) auf:

| Belastung/Temperatur | Schmelzflussindex [g/10 min] |
|---|---|
| 2.16 kg/150°C | 15 bis 40, bevorzugt 20 bis 35 |
| 2.16 kg/120°C | 0.5 bis 5, bevorzugt 1 bis 4 |
| 2.16 kg/100°C | 0.1 bis 1, bevorzugt 0.2 bis 0.6 |

PVB-Folien mit den genannten Schmelzflussindizes füllen während des Laminierprozesses die an den Solarzelleneinheiten bzw. deren elektrischen Verbindungen vorhandenen Hohlräume aus. Weiterhin verschmelzen die PVB-Folien blasen- und nahtfrei miteinander, so dass ein optisch einwandfreies Produkt erhalten wird.

Neben der Reissfestigkeit ist die Haftung der PVB-Folien an Glas und an den Solarzelleneinheiten von Bedeutung. Der Grad der Splitterbindung von PVB-Folie in Verbundsicherheitsglas wird durch den sogenannten Pummeltest ermittelt. Die Durchführung dieses Tests ist dem Fachmann bekannt bzw. in WO 03/033583 A1 beschrieben. Je nach Verwendung sollten die erfindungsgemäßen Solarmodule Pummelwerte von 3 bis 6 (hoher Penetrationsschutz) oder 7 bis 10 (gute Splitterbindung, z.B. bei Überkopf-Verglasungen) aufweisen. Bevorzugt wird ein Kompromiss dieser Eigenschaften mit Pummelwerten von 6 bis 8 angestrebt.

Das Haftungsvermögen von PVB-Folien an Glas kann durch die Zugabe von Haftungsregulatoren wie z. B. die in WO 03/033583 A1 offenbarten Alkali- und/oder Erdalkalisalze von organischen Säuren eingestellt werden. Als besonders geeignet haben sich Kaliumacetat und/oder Magnesiumacetat herausgestellt. Zum Erhalt von hohen Pummelwerten kann es erforderlich sein, PVB-Folien ohne Zusatz von Haftungsregulatoren wie Alkali- und/oder Erdalkalisalze einzusetzen.

Weiterhin sind die Sicherheitseigenschaften der erfindungsgemäßen Solarmodule durch die Haftungseigenschaften der PVB-Folien an Glas bestimmt. Diese können durch die Messung der Kompressionsscherhaftung beschrieben werden.

Bei der Messung der Folienhaftung an Glasoberflächen sind die unterschiedlichen Oberflächeneigenschaften von Flachglas zu beachten. Bei der Herstellung von Flachglas ist eine Seite des Glases dem Zinnbad und die andere Seite der Luft zugewandt, was die Zinn-Dotierung der Badseite zur Folge hat. Die unterschiedlichen Seiten von Flachglas weisen auf Grund der Dotierung eine unterschiedliche Haftung der PVB-Folie auf. Üblicherweise werden daher Haftungseigenschaften von PVB-Folien in Glaslaminaten gemessen, indem die Folie jeweils zu gleichen Seiten der Glasscheiben Kontakt hat. Die Angaben zur Kompressionsscherhaftung an Luft/Luft- bzw. Zinn/Zinn-Glasoberflächen beziehen sich auf entsprechend aufgebaute Laminate.

Die Bestimmung der Kompressionsscherhaftung erfolgt nach den im Folgenden genauer beschriebenen, in Anlehnung an die in EP 0 067 022 bzw. DE 197 56 274 A1 genannten Methoden. Die anderen Messungen werden nach den angegebenen Normen durchgeführt. Alle Prüfungen erfolgen an Glas/Glaslaminaten mit identischem Aufbau wie die erfindungsgemäßen Solarmodule, jedoch ohne Solarzellen.

Zur Verwendung in erfindungsgemäßen Solarmodulen geeignete PVB-Folien weisen bevorzugt eine Kompressionsscherhaftung an Luft/Luft-Glasoberflächen von 10 - 30 N/mm², bevorzugt 15 - 25 N/mm² und insbesondere 15-20 N/mm² auf.

Die Kompressionsscherhaftung dieser Folien an Glasoberflächen bezüglich der Zinn/Zinn-Seiten des Glases beträgt vorzugsweise 10 - 25 N/mm², bevorzugt 15 - 20 N/mm².

Erfindungsgemäße Solarmodule werden mit einer vorderen und oder hinteren Glasscheibe, z.B. aus Floatglas oder ganz oder teilweise vorgespanntem Glas, jeweils bevorzugt mit einer Dicke zwischen 3 und 10 mm ausgerüstet. Die Dicke der PVB-Folien liegt bei 0.38, 0.51, 0.76, 1.14 und/oder 1.52 mm.

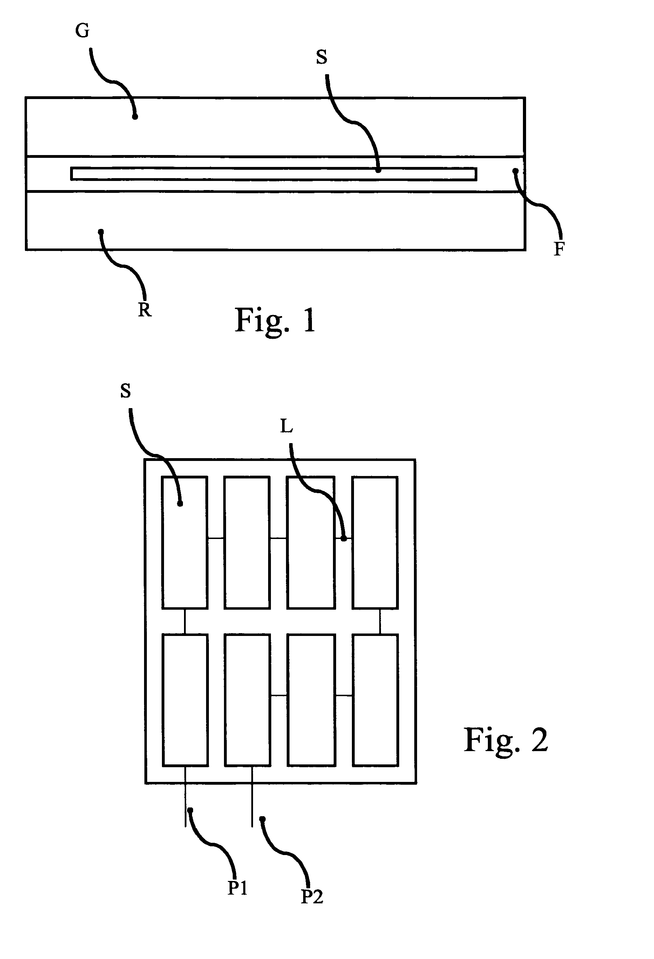

In Fig.1 ist der Aufbau eines erfindungsgemäßen Solarmoduls skizziert. Hier stehen G für die Glasscheibe (Vorderseite) und R für die rückwärtige Abdeckung. Die Solarzellen S sind von miteinander verschmolzenen PVB-Folien F eingekapselt.

Es ist möglich, die vordere Glasscheibe zur Erhöhung der Sicherheit als Verbundsicherheitsglas d. h. als Laminat aus mindestens zwei Glasscheiben und mindestens einer PVB-Folie auszuführen.

Die rückwärtige Abdeckung der Solarmodule kann aus Glas, Kunststoff oder Metall bestehen. Es ist ebenfalls möglich, eine solche Abdeckung aus Glas als Verbundverglasung bzw. als Isolierverglasung mit einem Gaszwischenraum auszuführen. Selbstverständlich ist auch die Kombination dieser Maßnahmen möglich.

Die in den Solarmodulen eingesetzten Solarzellen müssen keine besonderen Eigenschaften besitzen. Es können mono-, polykristalline oder amorphe Systeme eingesetzt werden. Die Dicke der kristallinen Solarzellen beträgt bevorzugt 0.1 bis 0.5 mm. Um eine ausreichende Spannung zu liefern, werden die Solarzellen in Einheiten von 5 bis 20 Zellen elektrisch miteinander verbunden.

Um die Bruchsicherheit der erfindungsgemäßen Solarmodule zu erhöhen, werden die elektrischen Verbindungen der Solareinheiten miteinander bzw. die Stromabfuhr der Solareinheiten aus dem Solarmodul hinaus nicht durch Bohrungen durch die Vorder- bzw. Rückseite geführt. Zweckmäßigerweise werden die erforderlichen Leiterbahnen wie die Solarzellen selbst zwischen den PVB-Folien verlegt und so aus dem Solarmodul hinausgeführt. Fig. 2 zeigt einen solchen Aufbau, wobei S für die Solarzelleneinheiten, L für die Leiterbahnen zwischen den Solarzelleneinheiten und P1 und P2 für die stromabführenden Leiter stehen.

Das erfindungsgemäße Verfahren zur Herstellung der Solarmodulen wird bevorzugt so durchgeführt, dass eine PVB-Folie auf die rückwärtige Abdeckung des Solarmoduls gelegt und auf dieser Folie wiederum die Solarzelleneinheiten mit den verbindenden Leiterbahnen angeordnet werden. Anschließend wird die zweite PVB-Folie in einer Weise aufgebracht und die vordere Glasscheibe aufgelegt. Der so vorbereitete Schichtkörper wird abschließend unter erhöhtem oder vermindertem Druck und erhöhter Temperatur zu einem Laminat verarbeitet.

Zur Laminierung des so erhaltenen Schichtkörpers können die dem Fachmann geläufigen Verfahren mit und ohne vorhergehender Herstellung eines Vorverbundes eingesetzt werden.

Sogenannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung der erfindungsgemäßen Solarmodule Vakuumlaminatoren eingesetzt. Diese bestehen aus einer beheizbaren und evakuierbaren Kammer, in denen Verbundverglasungen innerhalb von 30 - 60 Minuten laminiert werden können. Verminderte Drücke von 0,01 bis 300 mbar und Temperaturen von 100 bis 200 °C , insbesondere 130 - 160 °C haben sich in der Praxis bewährt.

Erfindungsgemäße Solarmodule können als Fassadenbauteil, Dachflächen, Wintergartenabdeckung, Schallschutzwand, Balkon- oder Brüstungselement oder als Bestandteil von Fensterflächen verwendet werden.

### Kompressionsschertest

Zur Beurteilung der Haftung einer PVB-Folie wird der Kompressionsschertest in Anlehnung an DE 197 56 274 A1 an einem Glas/Glaslaminat ohne Solarzelle durchgeführt. Zur Herstellung der Prüfkörper wird die zu prüfende PVB-Folie zwischen zwei ebene Silikatglasscheiben des Formats 300 mm x 300 mm mit einer Dicke von 2 mm gebracht, in einem Vorverbundofen mit Kalanderwalzen zu einem Glas-Vorverbund entlüftet und anschließend in einem Autoklav bei einem Druck von 12 bar und bei einer Temperatur von 140 °C innerhalb von insgesamt 90 min. zu einem ebenen Verbundsicherheitsglas verpresst. Aus dem so hergestellten Verbundsicherheitsglas werden 10 Proben mit den Maßen 25,4 mm x 25,4 mm geschnitten. Diese werden unter einem Winkel von 45° in eine Prüfapparatur gemäß DE 197 56 274 A1 eingespannt, wobei die Tiefe der Aussparungen ca. 2/3 der jeweiligen Glasdicke beträgt. Die obere Hälfte wird mit einer stetig steigenden, genau vertikal nach unten gerichteten Kraft beaufschlagt, bis es zu einer Abscherung innerhalb des Prüfkörpers, d. h. der zu prüfenden Verbundsicherheitsglasscheiben, kommt.

Die Prüfparameter sind wie folgt:

| | |
|---|---|
| Prüfkörper: | quadratisch 25,4 mm x 25,4 mm |
| Verlegung: | untere Scheibe jeweils mit der Luft- bzw. Feuerseite zur Folie (Luft/Luft), oder obere und untere Scheibe jeweils mit der Zinnseite zur Folie (Bad/Bad) |
| Lagerung vor dem Versuch: | 4h bei Normklima 23°C/50% RLF |
| Vorschub: | 2,5 mm/min |
| Probenanzahl: | 10 |
| Auswertung: | Maximalkraft, die zur Abscherung der Folie vom Glas benötigt wird. Die Kraft wird auf die Probenfläche bezogen (in N/mm² oder psi) |

Für jeden Prüfkörper wird die bei der Abscherung ausgeübte Kraft von zehn gleichen Prüfkörpern linear gemittelt. Soweit in den nachfolgenden Beispielen und den Ansprüchen auf den mittleren Kompressionsschertest-Wert Bezug genommen wird, ist damit dieser Mittelwert aus 10 Messungen gemeint. Im übrigen wird auf die DE 197 56 274 A1 verwiesen.

### Beispiele:

Es wurden Verbundglasscheiben aus zwei Glasscheiben (Floatglas) und zwei Folien mit zwischengelegten Solarzellen durch Herstellung eines Vorverbundes mittels Vakuumverfahren bei ca. 130-140°C und nachfolgenden Autoklavenprozess produziert. Als Folie kam handelsübliche, zum Einbetten von Solarzellen geeignete Ethylen-Vinylacetat-Folie (EVA) und die erfindungsgemäße PVB-Folie zum Einsatz. Der Autoklavenprozess wurde für EVA-Folien bei 130°C, 30min Haltezeit, 9 bar, für die erfindungsgemäße PVB-Folie bei 140°C, 30 min Haltezeit, 12 bar durchgeführt.

Die Verbundverglasungen waren nach dem Autoklavenprozess blasenfrei und transparent; die Solarzellen lagen vom Polymerfilm vollständig umschlossen vor.

Die folgenden Verbundverglasungen (Abmessungen 900 x 1100 mm) wurden einem Durchwurftest nach DIN EN 356 unterzogen:

### Vergleichsbeispiel 1

- Material:: 4mm Glas, 3*0,4mm EVASAFE (Fa. Bridgestone)
- 1. Kugel:: Scheibe gebrochen.
- 2. Kugel:: breiter Riss.
- 3. Kugel:: Kugel fällt glatt durch.
- Testresutat:: Prüfklasse P2A nicht bestanden

### Vergleichsbeispiel 2

- Material:: 4mm Glas, 2*0,5mm handelsübliche Solar-EVA-Folie
- 1. Kugel:: Scheibe gebrochen.
- 2. Kugel:: Kugel fällt durch.
- Testresutat:: Prüfklasse P1A nicht bestanden

### Beispiel 1

- Material:: 4mm Glas, 2*0,5mm erfindungsgemäße PVB-Folie
- 1-3. Kugel:: kein Riss.
- Testresutat:: P1A sicher bestanden

### Beispiel 2

- Material:: 4mm Glas, 2*0,5mm erfindungsgemäße PVB-Folie
- 1. Kugel:: Scheibe gebrochen.
- 2. Kugel:: breiter Riss.
- 3. Kugel:: gehalten.
- Testresutat:: P2A bestanden

Es zeigte sich, das die mit erfindungsgemäßer PVB-Folie hergestellten Solarmodule neben einem transparenten Aufbau und sicher umhüllten Solarzellen die durchwurfhemmende Wirkung von Verbundsicherheitsglas der Prüfklassen P1A und P2A der DIN EN 356 besitzen. Diese Sicherheitsklassen werden von analogen Verbundverglasungen mit EVA-Folie nicht erfüllt.

## Patentansprüche

1. Solarmodul als Verbundsicherheitsglas, umfassend ein Laminat aus
a) einer Glasscheibe
b) mindestens einer Solarzelleneinheit, die zwischen zwei auf PVB basierenden Folien angeordnet ist und
c) einer rückwärtigen Abdeckung
**dadurch gekennzeichnet, dass**
mindestens eine der auf PVB basierenden Folien eine Reissfestigkeit von mindestens 16 N/mm² aufweist.

2. Solarmodul nach Anspruch 1
**dadurch gekennzeichnet, dass**
mindestens eine der auf PVB basierenden Folien einen Schmelzflussindex von 15 bis 40 g/10 min, gemessen bei einer Belastung von 2.16 kg und 150°C, aufweist.

3. Solarmodul nach Anspruch 1 oder 2
**dadurch gekennzeichnet, dass**
mindestens eine der auf PVB basierenden Folien in einem Glas/Glas-Laminat eine Kompressionsscherhaftung an Luft/Luft-Glasoberflächen von 10 bis 30 N/mm² aufweist.

4. Solarmodul nach einem der Ansprüche 1 bis 3
**dadurch gekennzeichnet, dass**
mindestens eine der auf PVB basierenden Folien in einem Glas/Glas-Laminat eine Kompressionsscherhaftung an Zinn/Zinn-Glasoberflächen von 10 bis 25 N/mm² aufweist.

5. Solarmodul nach einem der Ansprüche 1 bis 4
**dadurch gekennzeichnet, dass**
die rückwärtige Abdeckung aus Glas, Kunststoff, Metall, einer Verbundverglasung, und/ oder einer Isolierverglasung besteht.

6. Solarmodul nach einem der Ansprüche 1 bis 5
**dadurch gekennzeichnet, dass**
mindestens eine der beiden auf PVB basierenden Folien Schallschutzeigenschaften besitzt.

7. Solarmodul nach einem der Ansprüche 1 bis 6
**dadurch gekennzeichnet, dass**
die Stromabführung der Solarzelleneinheiten durch Leiterbahnen, die zwischen den auf PVB basierenden Folien verlegt sind, erfolgt.

8. Verfahren zur Herstellung eines Solarmodul als Verbundsicherheitsglas, durch Bereitstellen eines Körpers aus
a) einer Glasscheibe als Vorderseite
b) mindestens einer Solarzelleneinheit, die zwischen zwei auf PVB basierenden Folien angeordnet ist, wobei mindestens eine Folie eine Reissfestigkeit von mindestens 16 N/mm² aufweist und
c) einer rückwärtigen Abdeckung durch
laminieren des Körpers unter erhöhtem oder verringertem Druck und erhöhter Temperatur.

9. Verfahren nach Anspruch 8
**dadurch gekennzeichnet, dass**
die Laminierung bei einem verringertem Druck von 0.01 bis 300 mbar und einer Temperatur von 100 bis 200 °C durchgeführt wird.

10. Verwendung von Solarmodulen als Verbundsicherheitsglas nach einem der Ansprüche 1 bis 7 als Fassadenbauteil, Dachfläche, Wintergartenabdeckung, Schallschutzwand, Balkon- oder Brüstungselement oder als Bestandteil von Fenstern.

## Claims

1. Solar module as laminated safety glass, comprising a laminate consisting of
a) a glass pane
b) at least one solar cell unit, which is arranged between two PVB-based films and
c) a covering on the rear
**characterised in that**
at least one of the PVB-based films has a tear resistance of at least 16 N/mm².

2. Solar module according to Claim 1
**characterised in that**
at least one of the PVB-based films has a melt flow index of 15 to 40 g/10 min, measured with a load of 2.16 kg and at 150°C.

3. Solar module according to Claim 1 or 2
**characterised in that**
at least one of the PVB-based films in a glass/glass laminate has a compressive shear bond strength at air/air glass surfaces of 10 to 30 N/mm².

4. Solar module according to one of Claims 1 to 3
**characterised in that**
at least one of the PVB-based films in a glass/glass laminate has a compressive shear bond strength at tin/tin glass surfaces of 10 to 25 N/mm².

5. Solar module according to one of Claims 1 to 4
**characterised in that**
the covering on the rear consists of glass, plastic, metal, laminated glazing and/or insulating glazing.

6. Solar module according to one of Claims 1 to 5
**characterised in that**
at least one of the two PVB-based films has soundproofing properties.

7. Solar module according to one of Claims 1 to 6
**characterised in that**
electricity is conducted away from the solar cell units by means of conductor tracks which are laid between the PVB-based films.

8. Method for manufacturing a solar module consisting of laminated safety glass by producing a body consisting of
a) a glass pane as the front side
b) at least one solar cell unit, which is arranged between two PVB-based films, wherein at least one film has a tear resistance of at least 16 N/mm² and
c) a covering on the rear by
laminating the body under elevated or reduced pressure and at elevated temperature.

9. Method according to Claim 8
**characterised in that**
the lamination is carried out at a reduced pressure of 0.01 to 300 mbar and at a temperature of 100 to 200 °C.

10. Use of solar modules as laminated safety glass according to one of Claims 1 to 7 as a facade component, roof surface, conservatory covering, noise barrier, balcony or parapet element or as a component of windows.

## Revendications

1. Module solaire faisant office de verre de sécurité feuilleté, comprenant un stratifié composé de
a) une feuille de verre,
b) au moins une unité de cellule solaire, qui est disposée entre deux feuilles à base de PVB,
c) un vitrage de couvercle arrière,
**caractérisé en ce que**
au moins une des feuilles à base de PVB présente une résistance à la déchirure d'au moins 16 N/mm².

2. Module solaire selon la revendication 1,
**caractérisé en ce que**
au moins une des feuilles à base de PVB présente un indice de fusion de 15 à 40 g/10 min, mesuré en présence d'une charge de 2,16 kg et 150°C.

3. Module solaire selon la revendication 1 ou 2,
**caractérisé en ce que**
au moins une des feuilles à base de PVB présente dans une stratification verre/verre une adhérence en cisaillement de compression sur des surfaces de verre air/air de 10 à 30 N/mm².

4. Module solaire selon une des revendications 1 à 3,
**caractérisé en ce que**
au moins une des feuilles à base de PVB présente dans une stratification verre/verre une adhérence en cisaillement de compression sur des surfaces de verre étain/étain de 10 à 25 N/mm².

5. Module solaire selon une des revendications 1 à 4,
**caractérisé en ce que**
le vitrage de couvercle arrière est constitué de verre, matière plastique, de métal, d'un vitrage feuilleté et/ou d'un vitrage isolant.

6. Module solaire selon une des revendications 1 à 5,
**caractérisé en ce que**
au moins une des deux feuilles à base de PVB possède des propriétés insonorisantes.

7. Module solaire selon une des revendications 1 à 6,
**caractérisé en ce que**
la conduction du courant hors des unités de cellules solaires est effectuée par des pistes conductrices, qui sont placées entre les feuilles à base de PVB.

8. Procédé de fabrication d'un module solaire faisant office de verre de sécurité feuilleté, en fournissant un corps composé de :
a) une feuille de verre comme côté avant,
b) au moins une unité de cellule solaire, qui est disposée entre deux feuilles à base de PVB, moyennant quoi au moins une feuille présente une résistance à la déchirure d'au moins 16 N/mm² et
c) un vitrage de couvercle arrière par
stratification du corps sous une pression accrue ou diminuée et une température accrue.

9. Procédé selon la revendication 8,
**caractérisé en ce que**
la stratification est effectuée en présence d'une pression diminuée de 0,01 à 300 mbar et d'une température de 100 à 200°C.

10. Utilisation de modules solaires faisant office de verre de sécurité feuilleté selon une des revendications 1 à 7 comme composant de façade, surface de toit, toiture de jardin d'hiver, paroi anti-bruit, élément de balcon ou de balustrade ou comme composant de fenêtres.
